Europäisches Patentamt

European Patent Office

Office européen des brevets

(11) Publication number: **0 242 748**
**A1**

## (12) EUROPEAN PATENT APPLICATION

(21) Application number: **87105401.1**

(22) Date of filing: **11.04.87**

(51) Int. Cl.⁴: **H01L 27/14 , H01L 29/78**

(30) Priority: **17.04.86 US 853299**

(43) Date of publication of application:
**28.10.87 Bulletin 87/44**

(84) Designated Contracting States:
**DE FR GB IT**

(71) Applicant: **HONEYWELL INC.**
**Honeywell Plaza**
**Minneapolis Minnesota 55440(US)**

(72) Inventor: **Gurnee, Mark N.**
**718 Grove Street**
**Framingham Massachusetts 01701(US)**

(74) Representative: **Rentzsch, Heinz et al**
**Honeywell Europe S.A. Holding KG Patent-**
**und Lizenzabteilung Kaiserleistrasse 55**
**D-6050 Offenbach am Main(DE)**

(54) **Bipolar/Mos input circuit for photovoltaic detectors.**

(57) A bipolar/MOS input circuit for coupling signals from one of an array of photovoltaic detectors to a CCD or CMOS multiplexer comprises a bipolar transistor (14) having a common base configuration. Current ($I_s$) produced by the detector is applied to the emitter (16) of the transistor. An insulated well gate (26) is formed adjacent the collector (22) of the transistor. An insulated reference gate (24) is located between the collector (22) and the well gate (26). Voltage applied to the base (20) of the transistor is adjusted so that the magnitude of current, minority carriers, of the semiconductor base, flowing from the collector (22) to the potential well beneath the well gate (26) substantially equals the signal current produced by the photovoltaic detector. The potential well under the well gate can be the first storage well of a CCD multiplexer (26, 28)

*FIG. 2*

EP 0 242 748 A1

## BIPOLAR/MOS INPUT CIRCUIT FOR PHOTOVOLTAIC DETECTORS

This invention is related to EP-A S.N. 87 105 402.9 (A3209693) "Multiplexer Cell for Photovoltaic Detectors" filed concurrently with this application. The disclosure of the above identified application is hereby incorporated by reference into this application.

The invention relates to circuits for coupling signals from photovoltaic (PV) detectors to a muliplexer, such as a charge coupled device (CCD).

Prior art circuits for coupling signals from PV detectors to a CCD multiplexer connect the detector to the source of a silicon field effect transistor (MOSFET). By suitable adjustment of the MOSFET gate potential, the detector current can be made to flow to the drain of the MOSFET which is often the first storage well of a conventional CCD muliplexer. This prior art technique often suffers from poor signal injection efficiency because the transconductance of MOSFETs is low, especially for input currents having a magnitude corresponding to that of which the MOSFET operates above its threshold level.

Prior art coupling circuits further suffer from large input offset voltage variations inherent in single ended MOSFET circuits. The two foregoing shortcomings impose stringent requirements on the photovoltaic detectors to obtain good signal to noise performance, especially at low frequencies where detector noise which is an inverse function of frequency may be high due to the operation of the detector off of a zero bias voltage.

It is therefore an object of this invention to provide an improved input circuit for a photovoltaic detector, and in particular an input circuit having high input signal coupling efficiency and in which variations in detector bias voltages are more effectively compensated, or corrected.

These objects are achieved by the invention as characterized in claim 1. Further modifications and embodiments of the invention are described in the dependent claims.

### BRIEF SUMMARY OF THE INVENTION

The present invention provides an improved input circuit for coupling signals from a photovoltaic detector, one of an array of such detectors lying in the focal plane of a photosensing device such as an infrared detector, to a multiplexer such as a CCD. The photovoltaic detector produces a signal current the magnitude of which is proportional to, or a function of, the intensity of incident electromagnetic radiation. A bipolar transistor in the common base configuration is formed in a portion of the semiconductor substrate on which is also formed a CCD or CMOS multiplexer. Current from the photovoltaic detector is connected to the emitter of the bipolar transistor. An insulated gate is formed closely adjacent to the collector, and it is used to form a charge storage well, or to control the flow of minority charged carriers from the collector of the bipolar transistor to a storage well under an adjacent well gate. The constant voltage applied to the insulated gate closest to the collector establishes the collector voltage of the transistor. Thus, no voltage is directly applied to the collector. The storage well into which the charge flows from the collector can also be the first storage well of a CCD multiplexer, for example.

### BRIEF DESCRIPTION OF THE DRAWINGS

Other objects, features and advantages of the invention will be readily apparent from the following description of certain preferred embodiments thereof, taken in conjunction with the accompanying drawings, although variations and modifications may be effected without departing from the spirit and scope of the novel concepts of the disclosure, and in which:

Figure 1 is a cross-sectional view, partly - schematic, of the bipolar/MOS input circuit for a photovoltaic detector in accordance with one embodiment of the invention; and

Figure 2 illustrates the potentials applied to various insulated gates of the circuit illustrated in Figure 1 and indicates the charge storage capacity of the potential well under the well electrode of the input circuit of the present invention.

### DESCRIPTION OF THE PREFERRED EMBODIMENT

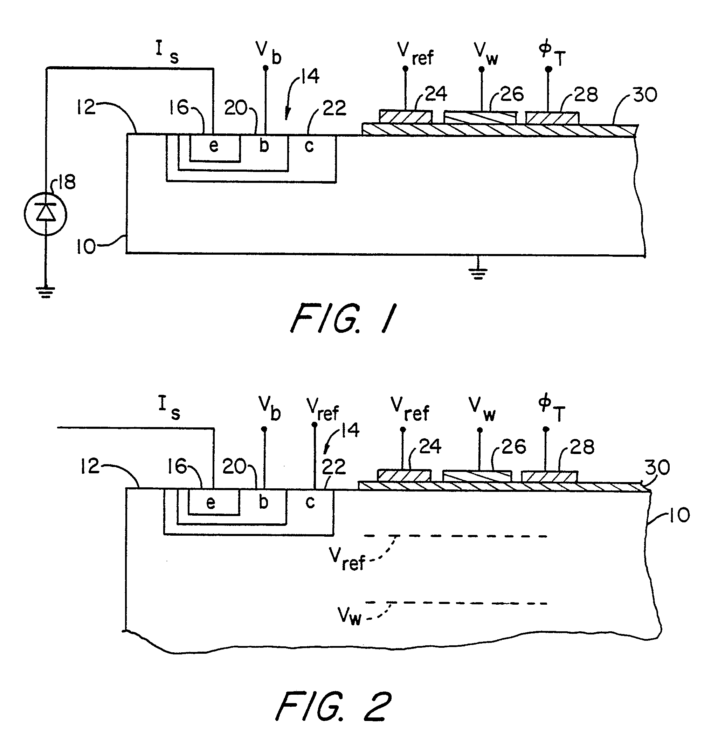

In Figure 1, a p-type semiconductor substrate 10 has diffused into its upper surface 12 a bipolar transistor 14 having a common base configuration. In the preferred embodiment transistor 14 is an npn type transistor. Emitter 16 of transistor 14 is connected to photovoltaic detector 18. Detector 18 is one of a plurality of such detectors forming an array lying, or located, in the focal plane of a photosensing device. Base 20 of bipolar transistor 14 is connected to a source of DC potential $V_b$. Collector 22 is not directly connected to a source of potential, its potential is set to a predetermined constant level determined by the voltage $V_{ref}$ applied to insulated gate 24 located adjacent to collector 22. Insulated gate 26 has applied to it a voltage $V_w$ having a greater magnitude than $V_{ref}$ to form a storage well to collect minority carriers, electrons in the preferred embodiment, which flow from collector 22. The magnitude of $V_{ref}$ and $V_w$ are illustrated schematically in Figure 2. In the preferred embodiment the storage well under well gate 26 is the first storage well of a conventional CCD multiplexer of which transfer gate 28 to which is applied an appropriately clocked transfer voltage $\emptyset_t$ is also an element.

Gates 24, 26 and 28 are electrically insulated from semiconductor substrate 10 by thin insulating layer 30 formed on a portion of the upper surface 12 of substrate 10. Typically layer 30 is a layer of silicon dioxide $SiO_2$. It will be appreciated that although substrate 10 is disclosed as being a p-type semiconductor material in the preferred embodiment, an n-type semiconductor material could also be used with a reversal of potentials of applied voltages and with bipolar common base transistor 14 being a pnp-type transistor.

In operation, the collector voltage of transistor 14 is set to a substantially constant level by the voltage $V_{ref}$ applied to reference gate 24. The voltage $V_w$ applied to well gate 26 is set to a higher, more positive, voltage than $V_{ref}$ to create a storage well into which minority carriers, electrons, flow from collector 22 of bipolar transistor 14. The magnitude of this current is adjusted to be substantially equal to the total background and signal current $I_s$ produced by photovoltaic detector 18 by adjusting the magnitude of $V_b$ by means of a potentiometer, which is not illustrated, for example, to set the voltage $V_b$ of base 20 of transistor 14 to a level at which circuit flow from collector 22 to the potential well under well gate 26 equals $I_s$.

Variations in the bias voltage of the detectors of an array of such detectors lying in a focal plane of a photosensing device are compensated, or substantially eliminated, because of the inherent uniformity of the emitter to base voltage of the bipolar transistor to the emitter of which the output current of the detector is applied. Variations in detector bias voltage $V_b$ can be controlled to within ± 5 millivolts, or less, which is substantially smaller than the ± 25 to 50 millivolts achievable with prior art MOSFET input circuits. As a result photovoltaic detectors in an array can be operated more closely to the desired magnitude of their respective bias voltages, typically zero, than with the use of MOSFET input circuits.

The input transconductance of a bipolar transistor is $g_m = qI/kT$ for all input currents. The value of $g_m$ for bipolar transistors is much higher than that obtained by MOSFETs, thus, the improved signal coupling efficiency achievable by the use of the bipolar input circuit of the present invention.

If desired, because of geometric constraints, or other reasons, reference gate 24 can be eliminated, and well gate 26 moved more closely adjacent to collector diffusion 22 of bipolar transistor 14. For a correctly designed transistor with high collector to emitter resistance (Rce) the change in surface potential under well gate 26 and thus any change in the collector potential of transistor 14 during input current integration will have little effect on the performance of transistor 14 as an input circuit to the potential well beneath well gate 26 which can be the first storage well of a CCD multiplexer.

Alternately, instead of the potential well under gate 26 being the first storage well of a CCD multiplexer, the voltage of the charge periodically accumulated in the potential well under gate 26 can be sensed and used as the input voltage signal to a multiplexer such as described in concurrently filed EP-A ......... entitled "Multiplexer Cell for Photovoltaic Detectors".

From the foregoing it is clear that this invention provides an improved bipolar input circuit for photovoltaic detectors, which input circuit has high input signal coupling efficiency and which more effectively compensates for variations in detector bias voltage.

## Claims

1. An input circuit for a photovoltaic detector (18) for producing a detector signal ($I_S$) ;
**characterized by**
a semiconductor substrate (10);
a bipolar transistor (14) formed on the substrate (10), said transistor having an emitter (16), a base (20) and a collector (22);
circuit means for applying the detector signal ($I_S$) to the emitter (16) of the bipolar transistor (14);
an insulated gate means (24, 26) formed on the substrate (10) adjacent to the collector (22) for forming a potential well within which minority charge carriers flowing from the collector (22) are periodically accumulated; and
a multiplexer (26, 28), the minority carriers periodically accumulated in the potential well ($V_w$) being an input signal to the multiplexer.

2. An input circuit according to claim 1, **characterized in that** the insulated gate means includes a reference gate (24) and a well gate (26), the potential applied to the well gate (26) being greater than the potential applied to the reference gate (24).

3. An input circuit according to claim 2 or 3, **characterized in that** the multiplexer (26, 28) is a charge coupled device and the potential well formed by the insulated gate means (26) is the first storage well of the multiplexer.

4. An input circuit according to claim 1, 2 or 3 for a photovoltaic detector producing a detector signal ($I_S$), the magnitude of which is proportional to the intensity of incident electromagnetic radiation; **characterized in that**

the well gate forms a potential wall in the substrate (10) under the well gate (26) adjacent the reference gate (24);

the reference (24) and well gates (26) are electrically insulated from the substrate; and

a CCD multiplexer is formed on the substrate (10), the potential well under the well gate (26) being the source of charge packets transferred by the CCD.

5. An input circuit according to one of the preceding claims, **characterized by** means for producing a reference voltage ($V_{ref}$) which is connected to the reference gate (24) and means for producing a well voltage ($V_w$) which is connected to the well gate means (26), whereat the reference voltage ($V_{ref}$) connected to the reference gate (24) determines the voltage of the collector (22) of the bipolar transistor (14).

6. An input circuit according to one of the preceding claims, **characterized in that** the detector signal ($I_s$) is an electric current.

7. An input circuit according to one of the preceding claims, **characterized in that** the semiconductor substrate (10) is of the p-type.

8. An input circuit according to one of the preceding claims, **characterized in that** the bipolar transistor (14) is of the npn type and has a common base configuration.

9. An input circuit according to claim 8, **characterized by** means for producing a base voltage ($V_b$) and for applying the base voltage ($V_b$) to the base (20) of the bipolar transistor (14), the magnitude of the base voltage causing the current flowing from the collector (22) to the potential well formed by the well gate (26) to substantially equal the detector signal ($I_s$) produced by the photovoltaic detector (18).

10. An input circuit according to one of the preceding claims, **characterized in that** the photovoltaic detector (18) is one of a plurality of detectors lying in the focal plane of a photosensing device.

FIG. 1

FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | INTERNATIONAL ELECTRON DEVICES MEETING, TECHNICAL DIGEST, Washington, 4th-6th December 1978, pages 624-627, IEEE, New York, US; N. BLUZER et al.: "High speed bipolar CCD input structure" * Figure 1; pages 624,625: "Bipolar CCD input structure" * | 1 | H 01 L 27/14<br>H 01 L 29/78 |
| A | INTERNATIONAL CONFERENCE ON CHARGE COUPLED DEVICES, San Diego, 29th-31st October 1975, pages 53-58, University of Edingburgh, Edinburgh, GB; W. GRANT et al.: "Integrated CCD-bipolar structure for focal plane processing of IR signals" * Figure 2; pages 54-55: "II. Circuit description" * | 1,2,4, 10 | |
| A | INTERNATIONAL ELECTRON DEVICES MEETING, TECHNICAL DIGEST, Washington, D.C., 8th-10th December 1980, pages 335-337, IEEE, New York, US; B. MUNIER et al.: "Hybrid focal plane arrays for infrared imaging devices" * Figure 1 * | 1-4,6, 7,10 | TECHNICAL FIELDS SEARCHED (Int. Cl.4)<br><br>H 01 L<br>G 11 C |
| A | US-A-4 152 715 (C-SWANG) * Figure 1; claim 1 * | 1 | |

The present search report has been drawn up for all claims

| Place of search | Date of completion of the search | Examiner |
|---|---|---|
| THE HAGUE | 22-06-1987 | CARDON A. |